# EUROPEAN PATENT SPECIFICATION

(11) **EP 0 716 443 B1**
(45) Date of publication and mention of the grant of the patent: **11.10.2000**
(21) Application number: 95308767.3
(22) Date of filing: 05.12.1995
(51) Int. Cl.: H01L 21/77

(54) **Fabrication of integrated circuit having twin tubs**
Fabrikation einer integrierten Schaltung mit Zwillingswannen
Fabrication d'un circuit intégré ayant des cuves jumelées

(30) Priority: 08.12.1994 US 352257
(43) Date of publication of application: 12.06.1996
(73) Proprietor: AT&T Corp., New York, NY 10013-2412 (US)
(72) Inventor: Lee, Kuo-Hua, Orlando, Florida 32839 (US); Yu, Chen-Hua Douglas, Orlando, Florida 32836 (US)
(74) Representative: Johnston, Kenneth Graham

(56) References cited:
- EP-A- 0 254 973
- EP-A- 0 391 561

## Description

### Technical Field

This invention relates to methods for integrated circuit fabrication.

### Background of the Invention

Many CMOS integrated circuits are fabricated using a process termed the "twin tub" process. In the twin tub process, adjacent n and p type tubs are formed and, subsequently, complementary devices are formed in these tubs.

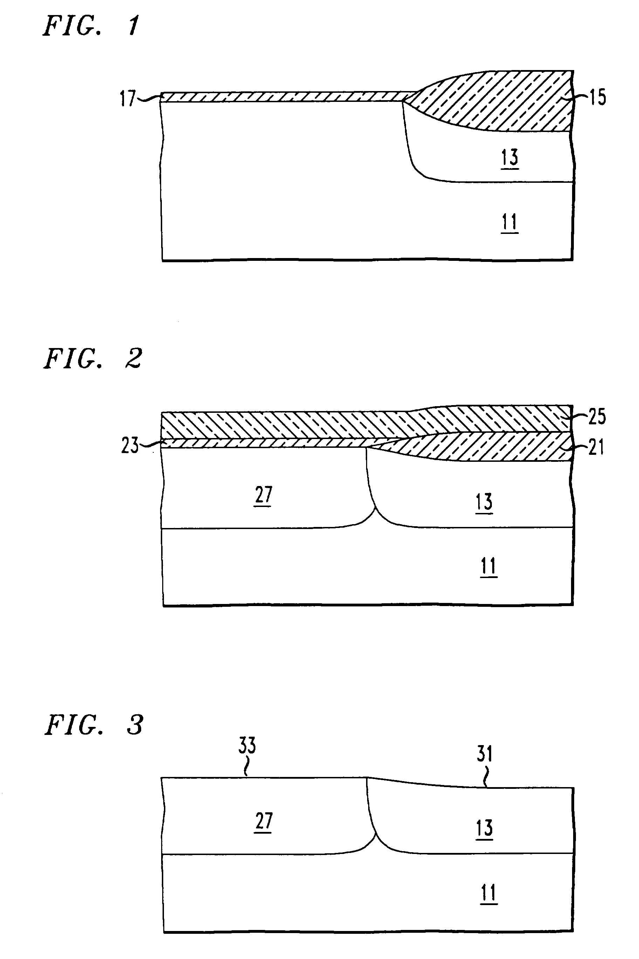

In a typical twin tub process, a portion of the substrate is masked, typically by layers of silicon dioxide and silicon nitride. Then, the masked substrate is exposed to a dopant species, perhaps boron. Usually an ion implantation process is performed. The ion implantation process forms a p-tub in those portions of the substrate which have not been masked by silicon dioxide and silicon nitride. After formation of the p-tub, a thick oxide is grown over the p-tub and the previously-formed silicon nitride layer is removed. Thus, for example, the structure depicted in FIG. 1 is formed.

In FIG. 1, reference numeral 11 denotes a substrate which may be silicon, doped silicon, epitaxial silicon, etc. Reference numeral 13 denotes a p-tub which has been formed by the process just described. Reference numeral 15 denotes a thick oxide layer which has been formed over p-tub 13. Reference numeral 17 denotes a silicon dioxide layer. The silicon nitride layer which previously covered silicon dioxide layer 17 has been removed. A typical thickness for oxide 15 is 4000Å (10Å = 1 nm); while a typical thickness for oxide layer 17 is 1000Å. The next step is to form an n-tub by directing an n-type dopant species at the structure depicted in FIG. 1. Of course, the thickness of oxide 15 must be great enough to protect p-tub 13 during the n-tub implantation.

After the n-tub implantation, a tub drive-in is performed. The drive-in is a thermal treatment which activates the dopants and allows the dopants to diffuse more deeply into the substrate. It is important during the drive-in step that the thickness of oxide 17 be great enough to prevent ambient boron from counterdoping the already-formed n-tub. However, if the thickness of layer 17 is substantially greater, then the thickness of layer 15 must be made correspondingly greater to provide adequate protection for the p-tub during the n-tub implantation. Unfortunately, if layer 17 and 15 are made substantially thicker, an undesirable height difference will occur at the boundary between the n and p tubs after layers 15 and 17 are removed in subsequent processing. The aforementioned height difference is undesirable because it creates lithographic and dielectric planarization problems during the later steps of integrated circuit fabrication.

Thus, those concerned with the development of integrated circuits have sought methods for adequately protecting the p-tub during n-tub implantation and, also, for adequately protecting the n-tub from contamination during subsequent tub thermal drive-in steps.

European patent application publication number 0254973 discloses a method for making twin tab integrated devices, in particular twin tub cmos devices, with a self-aligned separation trench using two masking steps for forming the tubs and the trench of the CMOS. The trench mask is obtained by at least one masking layer deposited on the substrate and having a window at the trench region obtained in a self-aligned manner employing the tub masks, which are dimensioned so as to mutually and ideally overlap at the trench region and to delimit the trench mask window.

European patent application number 0391561 discloses a method of forming a well of one conductivity type in a silicon substrate.

Thus according to the present invention there is defined a method of integrated circuit fabrication according to claim 1.

The invention illustratively includes masking a first portion of a substrate and then forming a first type conductivity tub in a second portion of the substrate. Then a material layer is formed over the second portion of the substrate and a second type conductivity tub is formed in the first portion of the substrate. Then the first and second portions of the substrate are covered with a second material layer. Both the first and second type tubs are exposed to an elevated temperature. The second material layer serves to protect the tubs from contamination by an ambient dopant. The first and second material layers are removed and transistors are formed in the tubs.

FIGS. 1, 2 and 3 are cross-sectional views which are useful in understanding an illustrative embodiment of the present invention.

Both the n and the p tub may be adequately protected by applicant's invention which may be understood with reference to FIG.2. Reference numeral 11 denotes a substrate. Generally the term "substrate" refers to a material body upon which other material layers may be formed. Reference numeral 13 denotes a p-tub. Reference numeral 21 denotes a thermally-formed oxide which may typically have a thickness of 1000-3000Å. Reference numeral 23 denotes a thermal oxide which may, illustratively, have a thickness of 100-300Å.

P-tub 13 has been formed in the manner described above. Thermal oxide 21 (which is much thinner than thermal oxide 15 depicted in FIG. 1) has been formed over p-tub 13. Next, n-tub 27 has been formed by an ion implantation of n-type dopant species. The thickness of oxide 21 has been found sufficient to protect p-tub 13. A typical n-type implant in is: phosphorous at 30 KEV, 4.5 E12.

After n-tub 27 has been formed, layer 25 is blanket deposited over oxides 23 and 21. Layer 25 is, desirably, plasma-enhanced TEOS. Other precursors may be used. The plasma-enhanced TEOS is formed at a comparatively low temperature. Layer 25 protects n-tub 27 from contamination by ambient boron during the next step which is a thermal tub drive-in.

After the thermal tub drive-in is performed, layer 25 is removed, for example, by wet etching. The resulting structure is illustrated in FIG. 3 with p-tub 13 and n-tub 27. The height difference between p-tub 13 and n-tub 27 (i.e., the height difference between surfaces 31 and 33) is comparatively small, being only the difference between the penetration depths of oxides 21 and 23.

## Claims

1. A method of integrated circuit fabrication comprising:
masking a first portion of a substrate (11);
forming a first type conductivity tub (13) in a second portion of said substrate;
forming a first material layer (21) over said second portion of said substrate;
forming a second type conductivity tub (27) in said first portion of said substrate;
covering said first portion and said first material layer over said second portion of said substrate with a blanket deposited second material layer (25);
performing a thermal tub drive-in step on said first (13) and second (27) type conductivity tubs, said second material layer (25) serving to protect said first (13) and second (27) tubs from contamination by an ambient dopant;
removing said first (21) and second (25) material layers.

2. The method of claim 1 in which said first material layer (21) is a thermal oxide.

3. The method of claim 1 in which said second material layer (25) is formed from plasma enhanced TEOS.

4. The method of claim 1 in which said ambient dopant is boron.

5. The method of claim 1 in which said first material layer (21) has a thickness between 1000 and 3000 Å (100 and 300 nm).

## Patentansprüche

1. Verfahren zur Herstellung von integrierten Schaltungen, bei dem:
ein erster Teil eines Substrats (11) abgedeckt wird;
in einem zweiten Teil des Substrats eine Wanne (13) eines ersten Leitfähigkeittyps ausgebildet wird;
über dem zweiten Teil des Substrats eine Schicht (21) aus einem ersten Material gebildet wird;
in dem ersten Teil des Substrats eine Wanne (27) eines zweiten Leitfähigkeittyps ausgebildet wird;
der erste Teil und die Schicht aus erstem Material über dem zweiten Teil des Substrats mit einer ganzflächig abgeschiedenen Schicht (25) aus zweitem Material bedeckt wird;
die Wannen des ersten (13) und zweiten (27) Leitfähigkeitstyps einem thermischen Wanneneintreibschritt unterworfen werden, wobei die Schicht (25) aus zweitem Material dazu dient, die erste (13) und zweite (27) Wanne vor einer Kontamination durch einen Umgebungsdotierstoff zu schützen;
die Schichten aus erstem (21) und zweitem (25) Material entfernt werden.

2. Verfahren nach Anspruch 1, wobei es sich bei der Schicht (21) aus erstem Material um ein thermisches Oxid handelt.

3. Verfahren nach Anspruch 1, bei dem die Schicht (25) aus zweitem Material aus plasmaunterstütztem TEOS gebildet wird.

4. Verfahren nach Anspruch 1, bei dem es sich bei dem Umgebungsdotierstoff um Bor handelt.

5. Verfahren nach Anspruch 1, bei dem die Schicht (21) aus erstem Material eine Stärke zwischen 1000 und 3000 Å (100 und 300 nm) aufweist.

## Revendications

1. Procédé de fabrication d'un circuit intégré comprenant :
le masquage d'une première partie d'un substrat (11) ;
la formation d'une cuve d'un premier type de conductivité (13) dans une deuxième partie dudit substrat ;
la formation d'une première couche de matière (21) par-dessus ladite deuxième partie dudit substrat ;
la formation d'une cuve d'un deuxième type de conductivité (27) dans ladite première partie dudit substrat ;
le recouvrement de ladite première partie et de ladite première couche de matière par-dessus ladite deuxième partie dudit substrat par une deuxième couche de matière déposée sous forme de couverture (25) ;
l'exécution d'une étape de diffusion profonde thermique de cuve sur lesdites cuves de premier (13) et deuxième (27) types de conductivité, ladite deuxième couche de matière (25) servant à protéger lesdites première (13) et deuxième (27) cuves contre la contamination par des impuretés ambiantes ;
l'élimination desdites première (21) et deuxième (25) couches de matière.

2. Procédé selon la revendication 1, dans lequel ladite première couche de matière (21) est un oxyde thermique.

3. Procédé selon la revendication 1, dans lequel ladite deuxième couche de matière (25) est formée à partir de TEOS activé par plasma.

4. Procédé selon la revendication 1, dans lequel lesdites impuretés ambiantes sont du bore.

5. Procédé selon la revendication 1, dans lequel ladite première couche de matière (21) a une épaisseur comprise entre 1000 et 3000 Å (100 et 300 nm).
